# EUROPEAN PATENT APPLICATION

(11) **EP 1 968 367 A1**
(43) Date of publication of application: **10.09.2008**
(21) Application number: 06843532.0
(22) Date of filing: 27.12.2006
(51) Int. Cl.: H05K 3/34, H01L 21/52

(54) **SOLDERING METHOD, SEMICONDUCTOR MODULE MANUFACTURING METHOD AND SOLDERING APPARATUS**

(30) Priority: 28.12.2005 JP 2005380353
(71) Applicant: KABUSHIKI KAISHA TOYOTA JIDOSHOKKI, Kariya-shi, Aichi 448-8671 (JP)
(72) Inventor: KIMBARA, Masahiko, Kariya-shi, Aichi 448-8671 (JP)
(74) Representative: TBK-Patent
(86) International application number: PCT/JP2006/326150
(87) International publication number: WO 2007/074889

(57) **Abstract**

A soldering method for soldering an electronic component to a circuit board is disclosed. The soldering method includes placing the electronic component on the bonding portion of the circuit board with solder arranged between the electronic component and the bonding portion, placing a weight on the electronic component, and heating and melting the solder while pressing the electronic component toward the circuit board with the weight. The weight is spaced from the electronic component while the temperature of the solder is still high after the melted solder wets the bonding portion and the bonding surface of the electronic component and spreads out therebetween.

## Description

### TECHNICAL FIELD

The present invention relates to a soldering method, a method for manufacturing a semiconductor module, and a soldering apparatus.

### FIELD OF THE INVENTION

When mounting electronic components, such as semiconductor elements, chip resistors, and chip capacitors, on a circuit board, the electronic components are normally bonded to the circuit board with solder. When an electronic component is soldered to the circuit board, the surface tension of melted solder between the electronic component and the circuit board may displace the electronic component. Further, the electronic component may be bonded to the circuit board without the melted solder being evenly spread out on the bonding surface of the electronic component.

Various methods have been proposed, for example, in patent documents 1 and 2 to solve these problems. Patent document 1 describes a method for placing a weight on an electronic component, which is soldered to a substrate that serves as a support, and soldering the electronic component while the electronic component is being pressed toward the substrate by the weight. Solder having a three-layer structure is used in the soldering method described in Patent Document 1. The three-layer solder includes a first soldering layer, which is formed from a material having a high melting point, and two second soldering layers, which are arranged on opposite sides of the first soldering layer. The second soldering layers are formed from a material having a lower melting point than the first soldering layer. The three-layer solder is arranged between the semiconductor element and the support, which supports the semiconductor member. The weight, which is placed on the semiconductor element, applies pressure to the three-layer solder. Heating or thermal processing is then performed to melt only the second soldering layers and bond the semiconductor element to the support.

Patent document 2 describes an apparatus for mounting an electronic component on a printed circuit board with melted solder. The apparatus includes a plurality of pressing members (pins) for elastically pressing the upper surface of an electronic component at a plurality of positions until the melted solder solidifies. The pins, which are arranged at generally regular intervals, have lower ends that are in contact with the upper surface of the electronic component arranged on a printed circuit board. The pins also have upper ends fixed to the lower end of a heating apparatus.

In the method described in patent document 1, the weight is placed on an electronic component, or a soldered component, during soldering. This avoids displacement of the electronic component and easily spreads out the solder over the entire bonding surface of the electronic component. However, the heat that melts the solder is easily transferred to the weight. When performing soldering with the weight in the prior art, the weight is left on the electronic component until the electronic component cools to a predetermined temperature after the melted solder solidifies. Thus, the heat of the weight is transferred to the electronic component. This lengthens the time required for the electronic component to cool does to a predetermined temperature and prolongs the soldering operation.

The apparatus described in patent document 2 uses the pins instead of the weight to press the electronic component. Without the weight, the electronic component does not require a long time to cool down. However, the structure of the apparatus becomes complicated due to the pins. In particular, the structure becomes further complicated when soldering a plurality of electronic components to a circuit board.
Patent Document 1: Japanese Laid-Open Patent Publication No. 6-163612
Patent Document 2: Japanese Laid-Open Patent Publication No. 2001-185841

### SUMMARY OF THE INVENTION

It is an object of the present invention to provide a soldering method, a manufacturing method for a semiconductor module, and a soldering apparatus that shorten the time required for a electronic component soldered to a circuit board to cool down to a predetermined temperature.

To achieve the above object, one aspect of the present invention provides a method for soldering a bonding surface of an electronic component to a bonding portion defined on a circuit board. The method includes placing the electronic component on the bonding portion of the circuit board with solder arranged between the electronic component and the bonding portion, placing a weight on the electronic component, heating and melting the solder while pressing the electronic component toward the circuit board with the weight, and spacing the weight from the electronic component while the temperature of the solder is still high after the melted solder wets the bonding portion and the bonding surface of the electronic component and spreads out therebetween.

Another aspect of the present invention provides a method for manufacturing a semiconductor module formed by soldering a bonding surface of an electronic component to a bonding portion defined on a circuit board. The method includes placing the electronic component on the bonding portion of the circuit board with solder arranged between the electronic component and the bonding portion, placing a weight on the electronic component, heating and melting the solder while pressing the electronic component toward the circuit board with the weight, and spacing the weight from the electronic component while the temperature of the solder is still high after the melted solder wets the bonding portion and the bonding surface of the electronic component and spreads out therebetween.

A further aspect of the present invention provides an apparatus for soldering electronic components respectively to a plurality of bonding portions defined on a circuit board. The apparatus includes a container which accommodates the circuit board in a state in which the electronic components are respectively placed on the bonding portions with solder arranged between the electronic components and the bonding portions. A plurality of weights are respectively arrangeable on the electronic components for pressing the electronic components toward the circuit board. A support is arranged in the container to position and support the circuit board. A weight holding jig is arranged above the support and capable of holding the weights at positions respectively facing the bonding portions of the circuit board on the support. A driver is arranged in the container for driving the weight holding jig so that the weights held by the weight holding jig are movable between a pressing position for pressing the electronic components on the circuit board, which is positioned on the support, and a spaced position spaced from the electronic components. A heating device heats and melts the solder.

### BRIEF DESCRIPTION OF THE DRAWINGS

Fig. 1 is a plan view showing a semiconductor module according to the present invention;
Fig. 2 is a cross-sectional view taken along line 2-2 in Fig. 1;
Fig. 3 is a schematic cross-sectional view of a soldering apparatus according to a first embodiment of the present invention for performing soldering on a semiconductor module;
Fig. 4(a) is a plan view showing a jig used when performing soldering, and Fig. 4(b) is a perspective view showing a weight used for soldering;
Fig. 5 is a plan view showing a weight holding jig used for soldering;
Fig. 6 is a schematic cross-sectional view illustrating the operation of the soldering apparatus shown in Fig. 3;
Fig. 7 is a schematic partial cross-sectional view of a semiconductor apparatus according to a second embodiment of the present invention for performing soldering on the semiconductor module shown in Fig. 1;
Fig. 8 is a partial cross-sectional view of a soldering apparatus in another embodiment;
Fig. 9(a) is a schematic plan view showing the layout of semiconductor elements and the shapes of weights according to a further embodiment, and Fig. 9(b) is a plan view showing a support plate;
Figs. 10(a) to 10(c) are schematic views showing the formation of a fillet when solder melts in a further embodiment;
Figs. 11(a) and 11(b) are schematic views showing the formation of a fillet when solder melts in a further embodiment;
Fig. 12(a) is a schematic view showing reflection light generated when the solder with a fillet is illuminated with light, and Fig. 12(b) is a schematic view showing reflection light generated when the solder without a fillet is illuminated with light; and
Fig. 13(a) is a plan view showing a jig, Fig. 13(b) is a schematic view showing the layout of light emitting and receiving devices, a jig, a ceramic substrate, a metal circuit, solder, and an electronic component.

### BEST MODE FOR CARRYING OUT THE INVENTION

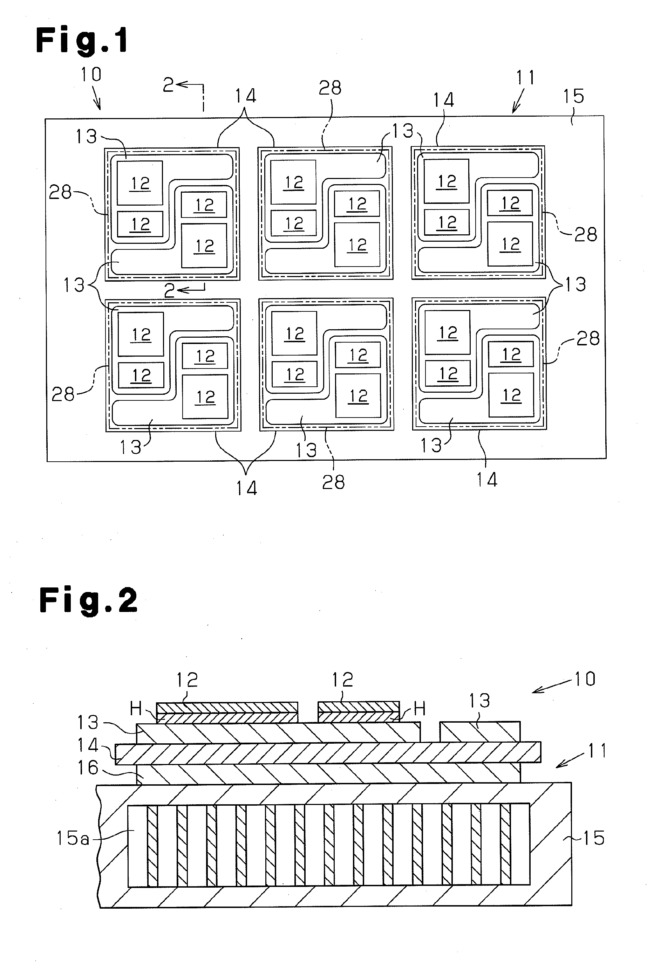

A first embodiment of the present invention will now be described with reference to Figs. 1 to 6.

As shown in Fig. 1, a semiconductor module 10 includes a circuit board 11 and a plurality of semiconductor elements 12, which serve as electronic components. The plurality of semiconductor elements 12 are soldered and bonded to the circuit board 11. The circuit board 11 includes a plurality of (six in the present embodiment) ceramic substrates 14. Metal circuits 13 are arranged on the surface of each ceramic substrate 14. Four semiconductor elements 12 are soldered to each ceramic substrate 14. At least three semiconductor elements 12 are laid out on each ceramic substrate 14 in a non-linear manner.

As shown in Fig. 2, the circuit board 11 includes the ceramic substrates 14, on which the metal circuits 13 are formed, and a metal heat sink 15, which is fixed to the ceramic substrates 14 with a metal plate 16 arranged between the heat sink 15 and the ceramic substrates 14. The circuit board 11 is a cooling circuit board, which includes the heat sink 15. The heat sink 15 is formed from, for example, aluminum metal or copper. The heat sink 15 has a refrigerant passage 15a, through which refrigerant flows. An aluminum metal refers to aluminum or an aluminum alloy. The metal plate 16, which functions as a bonding layer for bonding the ceramic substrates 14 and the heat sink 15, is formed from, for example, aluminum or copper.

The metal circuits 13 are formed from, for example, aluminum or copper. The ceramic substrates 14 are formed from, for example, aluminum nitride, alumina, or silicon nitride. The semiconductor elements 12 are bonded (soldered) to the metal circuits 13. More specifically, the metal circuits 13 serve as bonding portions for bonding the semiconductor elements 12 to the circuit board 11. In Fig. 2, character H indicates a soldering layer. The semiconductor elements 12 may be, for example, insulated gate bipolar transistors (IGBTs) or diodes.

A method for manufacturing the semiconductor module 10 will now be described.

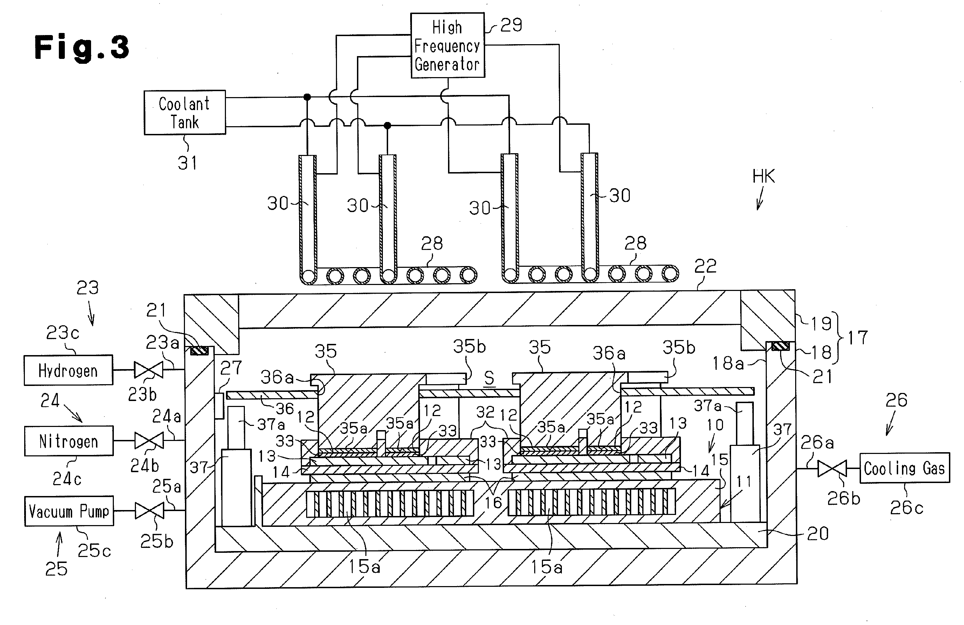

Fig. 3 schematically shows the structure of a soldering apparatus HK. The soldering apparatus HK is used to solder the semiconductor elements 12 to the metal circuits 13, which are arranged on the circuit board 11. In the present embodiment, the soldering apparatus HK is configured to solder the semiconductor module 10 shown in Fig. 3, that is, the semiconductor module 10 that includes the plurality of (six) ceramic substrates 14 arranged on the heat sink 15.

The soldering apparatus HK includes a sealable container (chamber) 17. The container 17 includes a main body 18 and a cover body 19. The main body 18 is a box-shaped and has an opening 18a. The cover body 19 opens and closes the opening 18a of the main body 18. A support base 20, which functions as a support for positioning and supporting the semiconductor module 10, is arranged on the main body 18. A packing 21, which comes into close contact with the cover body 19, is arranged in the open end of the main body 18.

The cover body 19 is large enough to close the opening 18a of the main body 18. When the cover body 19 is attached to the main body 18, a sealed space S is formed in the container 17. The cover body 19 includes a portion 22 facing toward the sealed space S. The portion 22 is formed from an electric insulating material that allows passage of magnetic lines of flux (magnetic flux). In the present embodiment, glass is used as the electric insulating material. The portion 22 of the cover body 19 is formed by a glass plate.

A reducing gas supply unit 23, which supplies reducing gas (hydrogen in the present embodiment) into the container 17, is connected to the main body 18. The reducing gas supply unit 23 includes a pipe 23a, a valve 23b arranged in the pipe 23a, and a hydrogen tank 23c. An inert gas supply unit 24, which supplies inert gas (nitrogen in the present embodiment) into the container 17, is connected to the main body 18. The inert gas supply unit 24 includes a pipe 24a, a valve 24b arranged in the pipe 24a, and a nitrogen tank 24c. A gas discharge unit 25, which discharges gas out of the container 17, is connected to the main body 18. The gas discharge unit 25 includes a pipe 25a, a valve 25b arranged in the pipe 25a, and a vacuum pump 25c. The soldering apparatus HK adjusts the pressure in the sealed space S together with the reducing gas supply unit 23, the inert gas supply unit 24, and the gas discharge unit 25 to pressurized or depressurize the sealed space S.

A supply unit (heat medium supply unit) 26, which supplies a heat medium (cooling gas) into the container 17 after soldering, is connected to the main body 18. The heat medium supply unit 26 includes a pipe 26a, a valve 26b arranged in the pipe 26a, and a gas tank 26c. The heat medium supply unit 26 supplies cooling gas to the heat sink 15 of the semiconductor module 10, which is accommodated in the container 17. The heat medium supplied from the heat medium supply unit 26 may be a cooling liquid. A temperature sensor (for example, a thermocouple) 27 for measuring the temperature in the container 17 is arranged on the main body 18.

High frequency heating coils 28 are arranged at an upper part of the soldering apparatus HK, specifically, above the cover body 19. The soldering apparatus HK of the present embodiment has six high frequency heating coils 28. As shown in Fig. 3, the six high frequency heating coils 28 are arranged to face the six ceramic substrates 14, respectively. In the present embodiment, when viewed from above, each high frequency heating coil 28 is large enough to cover a single ceramic substrate 14 and larger than the contour of the upper surface of a weight 35, which will be described later. Each high frequency heating coil 28 has a spiral shape (rectangular spiral shape) within a single plane and as a whole has the shape of a substantially tetragonal plate. The high frequency heating coils 28 are arranged to face the cover body 19, specifically, so as to face the glass plate 22. The high frequency heating coils 28 are electrically connected to a high frequency generator 29 of the soldering apparatus HK. The output of the high frequency generator 29 is controlled based on the measurement value of the temperature sensor 27, which is arranged in the container 17. Each high frequency heating coil 28 has a refrigerant passage 30, through which coolant flows. The high frequency heating coils 28 are connected to a coolant tank 31 of the soldering apparatus HK.

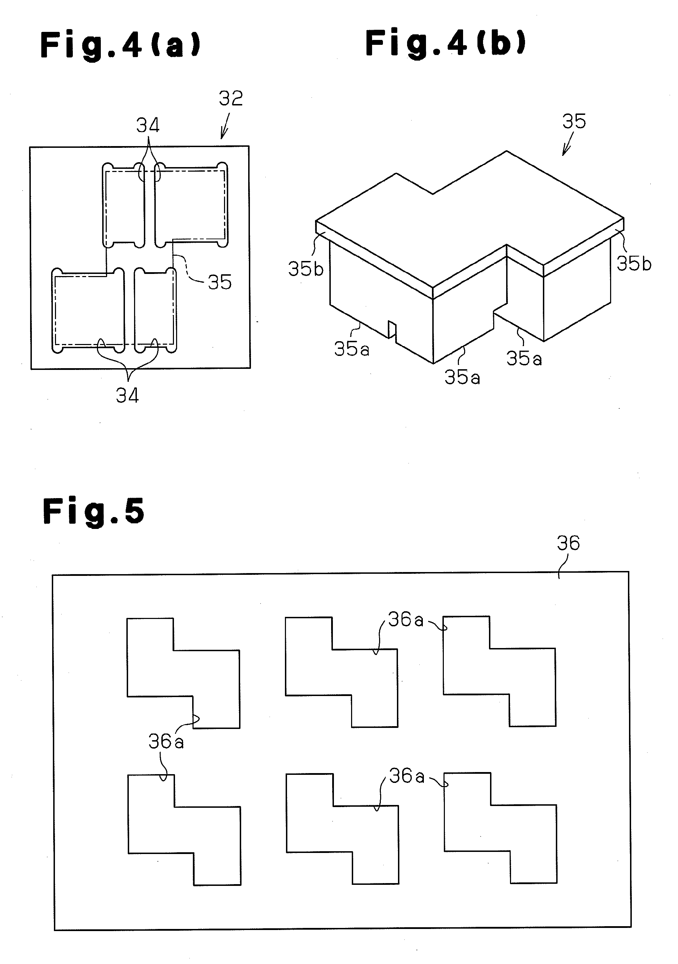

Fig. 4(a) shows a jig 32 used for soldering. Fig. 4(b) shows the weight 35 used for soldering. The jig 32 is flat and has the same size as each ceramic substrate 14 included in the circuit board 11. The jig 32 is formed from, for example, graphite or ceramics. As shown in Fig. 3, during soldering, the jig 32 is used to position solder sheets 33, the semiconductor elements 12, and the weights 35 on the ceramic substrate 14. The jig 32 has positioning holes 34. The holes 34 are formed in the jig 32 at positions corresponding to portions (bonding portions) of the ceramic substrate 14 to which the semiconductor elements 12 are bonded. Each hole 34 has dimensions corresponding to the size of the corresponding semiconductor element 12. In the present embodiment, a plurality of (four) semiconductor elements 12 are bonded to the ceramic substrate 14. Thus, a plurality of (four) holes 34 are formed in the jig 32.

The weight 35 is formed from a material that generates heat through electromagnetic induction. More specifically, the weight 35 is formed from a material that generates heat due to its electric resistance when current is generated when changes occur in the magnetic flux passing through the weight 35. More specifically, the weights 35 together with the high frequency heating coils 28 form a heating apparatus that heats and melts solder arranged between the bonding portions of the circuit board 11 and the semiconductor elements 12. In the present embodiment, the weights 35 are formed from stainless steel. During soldering, the weights 35 are arranged on the four semiconductor elements 12, which are positioned by the jig 32. Each weight 35 is large enough to come in contact with the upper surfaces of the four semiconductor elements 12 (non-bonded surfaces). More specifically, the weight 35 is large enough to extend over at least three semiconductor elements 12, which are laid out in a non-linear manner.

As shown in Figs. 4(a) and 4(b), the side of the weight 35 that comes in contact with the four semiconductor elements 12 during soldering includes a pressing surface. The pressing surface is shaped in correspondence with the layout of the four semiconductor elements 12. In the present embodiment, the pressing surface of the weight 35 is divided into four pressing surfaces 35a. The pressing surfaces 35a are shaped so that they are insertable into the four holes 34 of the jig 32 in a manner enabling contact with the corresponding semiconductor elements 12. The weight 35 further has a flange 35b at the opposite side of the pressing surfaces 35a. The flange 35b serves as a projection. Fig. 4(a) indicates the contour of the pressing surfaces 35a of the weight 35 with double-dashed lines and shows the positional relationship of the jig 32 and the weight 35 when inserted into the holes 34 of the jig 32.

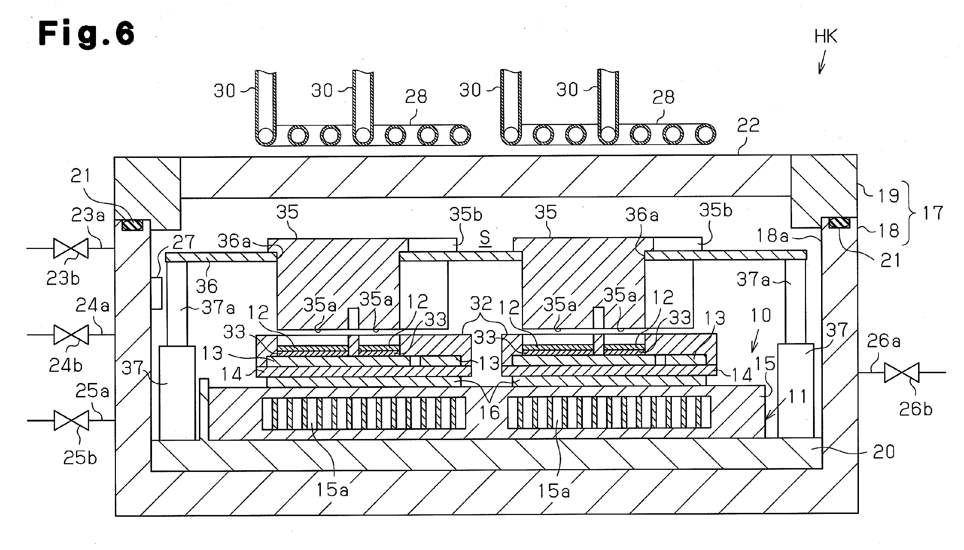

In the present embodiment, the soldering apparatus HK is configured so that the weights 35 are all movable between a position for pressing of the semiconductor elements 12 and a position spaced from the semiconductor elements 12. More specifically, a weight holding jig 36 and a plurality of drivers 37 are arranged in the container 17 as shown in Figs. 3 and 6. The weight holding jig 36 is arranged above the support base 20 to hold the weights 35 at positions facing bonding portions of the circuit board 11, which is positioned on the support base 20. The drivers 37 move the weight holding jig 36 between the pressing position and the spaced position.

The weight holding jig 36 is plate-like and formed from an electric insulating material (for example, ceramics), which allows passage of lines of magnetic flux. The weight holding jig 36 has holes 36a, the quantity of which corresponds to the quantity of the weights 35, to allow insertion of the weights 35 at portions lower than the flange 35b. The holes function as holding portions. The weight holding jig 36 is formed so that the weights 35 are movable to the spaced position at which the weights 35 are spaced from the semiconductor elements 12 in a state in which the flanges 35b of the weights 35 are engaged with the upper surface of the weight holding jig 36. As shown in Fig. 5, the holes 36a, in which the weights 35 are inserted, hold the weights 35 at a pressing position at which the weights 35 press the semiconductor elements 12.

As shown in Fig. 3, each driver 37 is formed by a linear actuator, such as an electric cylinder, and includes a piston rod 37a, which extends vertical upward. The piston rod 37a has a distal end, which can support the lower surface of the weight holding jig 36 and which can be spaced from the lower surface of the weight holding jig 36. In a state in which the weight holding jig 36 is held horizontally, the drivers 37 raise the piston rods 37a to move the weight holding jig 36 together with the weights 35 from the pressing position to the spaced position (refer to Fig. 6). Further, in a state in which the weight holding jig 36 is held horizontally, the drivers 37 lower the piston rods 37a to move the weight holding jig 36 together with the weights 35 from the spaced position to the pressing position (refer to Fig. 3).

In the state of Fig. 3, the piston rods 37a are moved so that their distal ends are located below the lower surface of the weight holding jig 36. As a result, the pressing surfaces 35a of the weights 35 come in contact with the non-bonding surfaces of the semiconductor elements 12 and the flanges 35b are spaced from the upper surface of the weight holding jig 36. Thus, the weights 35 press the semiconductor elements 12 with their weights.

A method for soldering the semiconductor elements 12 with the soldering apparatus HK will now be described. The soldering is one of the processes that are performed when manufacturing the semiconductor module 10. Before performing soldering with the soldering apparatus HK, a plurality of (six) ceramic substrates 14, each including a metal circuit 13, are bonded to a single heat sink 15 to form a soldering subject. The soldering subject corresponds to the semiconductor module 10 shown in Fig. 1 less the semiconductor elements 12.

When performing soldering, the cover body 19 is first removed from the main body 18 to open the opening 18a. Further, the weight holding jig 36 is removed from the main body 18. The soldering subject is then placed and positioned on the support base 20 of the main body 18. The jig 32 is then arranged on each ceramic substrate 14 of the soldering subject. The solder sheets 33 and the semiconductor elements 12 are arranged in the holes 34 of the jig 32. The solder sheets 33 are arranged between the metal circuits 13 and the semiconductor elements 12.

As shown in Fig. 6, the weight holding jig 36 is arranged at a position where the piston rods 37a located at projected positions (raised positions) support the weight holding jig 36. Subsequently, the cover body 19 is attached to the main body 18 to close the opening 18a. This forms the sealed space S in the container 17. The drivers 37 are then driven to lower the piston rods 37a. This lowers the weight holding jig 36. As a result, the weights 35 are lowered with the weight holding jig 36, and the portions of the weights 35 at the side of the pressing surfaces 35a are inserted in the corresponding holes 34 of the jig 32. As shown in the state of Fig. 3, the pressing surfaces 35a of the weights 35 come in contact with the non-bonding surfaces of the semiconductor elements 12, that is, the upper surfaces of the semiconductor elements 12, and the flanges 35b of the weights 35 are spaced from the upper surface of the weight holding jig 36. Each weight 35, which covers four semiconductor elements 12, presses the four semiconductor elements 12 with its own weight. In this state, the solder sheets 33, the semiconductor elements 12, and the weight 35 are arranged in an overlapping manner from the metal circuit 13 on each ceramic substrate 14.

In a state in which the circuit board 11, the solder sheets 33, the semiconductor elements 12, and the weights 35 are accommodated in the sealed space S, the high frequency heating coils 28 are arranged above the corresponding weights 35. The glass plate 22, which is attached to the cover body 19, is located between the high frequency heating coils 28 and the weights 35. In this embodiment, each high frequency heating coil 28 is formed and arranged so that when viewed from above, the high frequency heating coil 28 extends out of a region defined by the contour of the upper surface of the weight 35. In this embodiment, a large amount of magnetic flux is generated near the central part of the high frequency heating coil 28, which is spirally wound. Thus, it is preferable that the weight 35 be arranged near the central part of the high frequency heating coil 28.

The container 17 is depressurized by operating the gas discharge unit 25. The inert gas supply unit 24 is operated to supply nitrogen into the container 17 and fill the sealed space S with inert gas. The container 17 is repeatedly depressurized and supplied with the inert gas several times. Subsequently, the reducing gas supply unit 23 is operated to supply hydrogen into the container 17 and create a reducing gas atmosphere in the sealed space S.

Then, the high frequency generator 29 is operated to generate high frequency current that flows to each high frequency heating coil 28. As a result, the high frequency heating coil 28 generates high frequency magnetic flux, which passes through the corresponding weight 35. The passage of the magnetic flux generates eddy current in the weight 35. As a result, the weight 35, which is arranged in the magnetic flux of the high frequency heating coil 28, generates heat through electromagnetic induction. The heat is transferred from the pressing surfaces 35a of the weight 35 to the corresponding semiconductor elements 12. The heat generated in the weight 35 is transferred to the solder sheets 33 arranged on the bonding portions of the circuit board 11 through the pressing surfaces 35a of the weight 35 and the semiconductor elements 12. This heats the solder sheets 33. The solder sheets 33 melt when heated to a temperature greater than or equal to their melting points.

The semiconductor elements 12 are pressed by the corresponding weights 35 toward the circuit board 11. Thus, surface tension of the melted solder does not move the semiconductor elements 12. When the solder sheets 33 completely melt, the high frequency generator 29 is deactivated. The amount of high frequency current flowing to the high frequency heating coils 28 is controlled based on the detection results of the temperature sensor 27, which is arranged in the container 17. The atmosphere in the container 17 (sealed space S) is pressurized or depressurized in accordance with the progress in the soldering.

After the solder sheets 33 completely melt, the supply of current to the high frequency heating coils 28 is stopped. This stops heating the solder sheets 33. The heat medium supply unit 26 is then operated to supply cooling gas into the container 17. The cooling gas is blasted towards an inlet or outlet of the refrigerant passage 15a of the heat sink 15. The cooling gas supplied into the container 17 flows into the refrigerant passage 15a and around the heat sink 15 to cool the soldering subject. This cools the melted solder to a temperature lower than the melting point. As a result, the solder solidifies and bonds the metal circuits 13 and the semiconductor elements 12. This ends the soldering operation and completes the semiconductor module 10.

After the melted solder solidifies, the drivers 37 are driven to raise the piston rods 37a while the temperature of the solder is still high. As a result, the weights 35 are moved together with the weight holding jig 36 to the spaced position, at which the weights 35 are spaced from the semiconductor elements 12 as shown in Fig. 6. In this state, the solder cools to a predetermined temperature. Subsequently, the cover body 19 is removed from the main body 18. Further, the weight holding jig 36 and the jigs 32 are removed. Then, the semiconductor module 10 is removed out of the container 17.

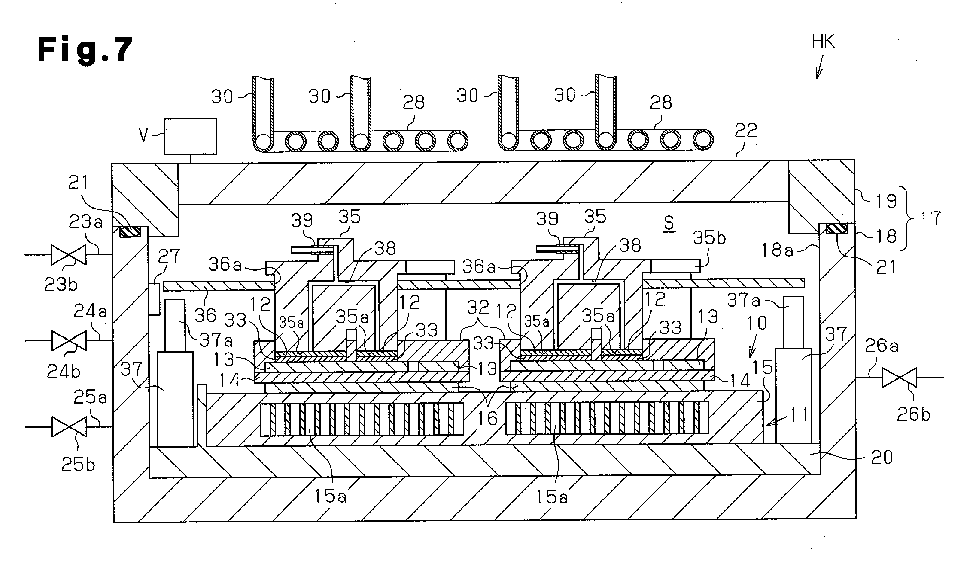

This embodiment has the advantages described below.
(1) In a state in which solder is arranged between the bonding portions of the circuit board 11 and the semiconductor elements 12 (electronic components), the weights 35 are placed on the semiconductor elements 12. The solder is heated and melted while the semiconductor elements 12 are pressed by the weights 35. Then, the heating is stopped. After the solder solidifies, the weights 35 are spaced from the semiconductor elements 12 when the temperature of the solder is still high. This prevents the heat of the weights 35 from being transferred to the semiconductor elements 12 after the soldering. The semiconductor elements 12 cool to a predetermined temperature in a shorter time as compared with when the weights 35 are not spaced. This structure shortens the time required for the soldering and shortens the manufacturing time for the semiconductor module 10.
(2) The weights 35, which are held by the weight holding jig 36, are all moved together between the pressing position and the spaced position. Accordingly, the operation is performed more easily and efficiently as compared with when the weights 35 are held by separate units and moved separately.
(3) The weight holding jig 36 is plate-like and includes the holes 36a for allowing insertion of the portions of the weights 35 lower than the flanges 35b. The flanges 35b of the weights 35 are engaged with the upper surface of the weight holding jig 36. In a state in which the flanges 35b are engaged with the upper surface of the weight holding jig 36, the weights 35 are movable together with the weight holding jig 36. This simplifies the structure of the weight holding jig 36.
(4) Soldering is performed in a state in which the plurality of semiconductor elements 12 are arranged on the circuit board 11 and pressed by the weights 35. The weight holding jig 36 includes the holes 36a for maintaining the positional relationship of the weights 35 when the weights 35 press the semiconductor elements 12. Accordingly, the weights 35 are easily moved between the pressing position and the spaced position with the weight holding jig 36, which has a simple structure.
(5) The soldering is performed in the container 17. The drivers 37 arranged in the container 17 drive the weight holding jig 36 to move the weights 35 between the pressing position and the spaced position. Accordingly, the weights 35 are moved between the pressing position and the spaced position even when the container 17 is closed.
(6) The drivers 37, which are linear actuators, are arranged in the container 17 so that their piston rods 37a project upward. The distal ends of the piston rods 37a of the drivers 37 support the weight holding jig 36, and the weight holding jig 36 can be spaced from the piston rods 37a of the drivers 37. This simplifies the structure of the drivers 37 and further prevents the weight holding jig 36 from interfering with the arrangement of the solder sheets 33 and the semiconductor elements 12 at predetermined positions on the circuit board 11.
(7) The solder is heated by heating the weights 35 through induction heating and transferring the heat of the weights 35 to the solder through the semiconductor elements 12. Accordingly, heat is intensively transferred to the solder. Thus, the solder is heated more efficiently than when entirely heating the circuit board 11 or the container 17.
(8) Each weight 35 is arranged to extend over at least three semiconductor elements 12, which are laid out in a non-linear manner. The solder is then heated and melted in a state in which the semiconductor elements 12 are pressed by the weights 35 toward the circuit board 11. Accordingly, when the solder melts, the weights 35 press the semiconductor elements 12 toward the metal circuits 13 in a horizontal state or a generally horizontal state. Thus, the melted solder between the semiconductor elements 12 and the metal circuits 13 spreads out evenly and entirely on the surfaces of the semiconductor elements 12 facing toward the metal circuits 13. When the solder cools to a temperature that is lower than or equal to its melting point, the solder solidifies at the bonding portion in an evenly spread out state.
(9) The semiconductor module 10 includes the circuit board 11, which serves as the cooling circuit board. The circuit board 11 includes the metal heat sink 15 and at least one ceramic substrate 14 fixed to the heat sink 15. The metal circuits 13 are formed on the surface of the ceramic substrate 14. The heat sink 15 includes the refrigerant passage 15a. The solder spreads out entirely on the surfaces of the semiconductor elements 12 facing towards the metal circuits 13 and solidifies in an evenly spread out state. The solder functions to relax stress produced at the bonding portions by absorbing differences in the coefficient of linear expansion between the semiconductor elements 12 and the metal circuits 13. This prevents variations in the fatigue life of the bonding portions.
(10) When soldering the semiconductor elements 12 to the circuit board 11 including the plurality of ceramic substrates 14, a high frequency heating coil 28 is arranged in correspondence with each ceramic substrate 14, and the weight 35 arranged on each ceramic substrate 14 generates heat with the corresponding high frequency heating coil 28. This is more efficient than when using a single high frequency heating coil 28 to generate heat for all of the weights 35 arranged on the ceramic substrates 14.
(11) The high frequency heating coils 28 are arranged outside the container 17 and not inside the container 17. This enables the volume of the container 17 to be minimized so that the container 17 can be reduced in size. The atmosphere in the container 17 is mainly adjusted by discharging air from the container 17 (evacuating the container 17), supplying and discharging inert gas (such as nitrogen gas) to and from the container 17, and supplying and discharging reducing gas (such as hydrogen) to and from the container 17. Thus, by reducing the volume of the container 17, the time required for discharging the air may be shortened and the consumption of energy required to discharge air (for example, the energy necessary to operate the vacuum pump 25c) may be shortened. Also, the time required for supplying or discharging inert gas or reducing gas may be shortened, the consumption of the necessary energy for supplying or discharging inert gas or reducing gas may be reduced, and the consumption of the supplied gas may be reduced.
(12) The cooling gas is supplied to the heat sink 15, which is joined to the ceramic substrates 14. This cools the bonding portions of the metal circuits 13. Thus, the bonding portions of the metal circuits 13 are efficiently cooled by the heat sink 15, and the time required to cool the bonding portions of the metal circuits 13 is shortened.
   A second embodiment of the present invention will now be described with reference to Fig. 7. The second embodiment differs from the first embodiment only in the structure of weights 35. Otherwise, the structure of the second embodiment is basically the same as the first embodiment. Similar parts will not be described in detail.
   In this embodiment, each weight 35 has a passage 38, which opens in a lower surface (pressing surfaces 35a) of the weight 35. Negative pressure is applied to the pressing surfaces 35a through the opening of the passage 38 to attract the semiconductor elements 12 and the like to the pressing surfaces 35a. A connector 39 is arranged on the weight 35 at a surface other than the lower surface. The connector 39 enables the passage 38 to be connected to a negative pressure source V, which is arranged outside the container 17. The passage 38 includes portions that extend vertically toward the pressing surfaces 35a of the weight 35. Such extended portions have lower ends that open in the corresponding pressing surfaces 35a. The connector 39 is connectable to the negative pressure source V by a flexible pipe (not shown).
   When performing a soldering operation with the soldering apparatus HK of this embodiment, the weights 35 are used as attraction units to attract the solder sheets 33 and the semiconductor elements 12 at positions corresponding to the holes 34 of the jig 32, which is arranged on each ceramic substrate 14. To arrange the solder sheets 33 at positions corresponding to the holes 34, for example, the cover body 19 is removed and the required number of solder sheets 33 are arranged outside the main body 18 in correspondence with the layout of the solder sheets 33 arranged on the circuit board 11. The weight holding jig 36 is then arranged so that the pressing surfaces 35a of the weights 35 are in correspondence with the solder sheets 33. In this state, each connector 39 is connected to the negative pressure source V by a pipe. Negative pressure from the negative pressure source V is communicated to the passage 38 of each weight 35. In a state in which the solder sheets 33 are attracted to the pressing surfaces 35a of the weights 35, the weight holding jig 36 is moved to a position where the weight holding jig 36 is supported by the piston rods 37a. Subsequently, the drivers 37 are driven to lower the piston rods 37a. As a result, the pressing surfaces 35a of the weights 35, to which the solder sheets 33 are attracted, are inserted into the holes 34 of the jigs 32 so as to arrange the solder sheets 33 at positions corresponding to the bonding portions. The communication of negative pressure to the passages 38 is stopped to cancel the attraction effect of the weights 35. The drivers 37 are then driven to raise the piston rods 37a. This moves the weights 35 together with the weight holding jig 36 to positions above the jigs 32.
   Then, the required number of semiconductor elements 12 are arranged outside the main body 18 in correspondence with the layout of the semiconductor elements 12 on the circuit board 11. The weight holding jig 36 is arranged so that the pressing surfaces 35a of the weights 35 are in correspondence with the semiconductor elements 12. In this state, negative pressure from the negative pressure source V is communicated to the passages 38 of the weights 35 to attract the semiconductor elements 12 to the pressing surfaces 35a of the weights 35. The weight holding jig 36 is then arranged at a position where it is supported by the piston rods 37a. The drivers 37 are then driven to lower the piston rods 37a. As a result, the weights 35 are inserted into the holes 34 of the jigs 32 in a state in which the semiconductor elements 12 are attracted to the pressing surfaces 35a of the weights 35. This arranges the semiconductor elements 12 on the solder sheets 33. This completes the arrangement of the semiconductor elements 12 and the weights 35 at predetermined positions as shown in Fig. 7. Subsequently, the communication of negative pressure to the passages 38 is stopped. Then, the connectors 39 and pipes are disconnected and the cover body 19 is arranged at the closing position. Thereafter, the soldering operation is performed in the same manner as in the first embodiment.
   In addition to advantages (1) to (12) described in the first embodiment, the present embodiment has the advantages described below.
(13) Each weight 35 includes the passage 38, which has an opening through which negative pressure is communicated to the pressing surfaces 35a to attract the semiconductor elements 12 and the like to the pressing surfaces 35a. Further, the connector 39, which enables connection of the passage 38 and the negative pressure source V, is arranged on the weight 35 at a surface other than the lower surface. Accordingly, the weight 35 may be used as an attraction unit. Further, the semiconductor elements 12 and the solder sheets 33 may be attracted to the lower surface (pressing surfaces 35a) of the weight 35 so that they are all arranged at the bonding portions (metal circuits 13) at the same time.
(14) The connectors 39 of the passages 38 are connected by the pipes to the negative pressure source V, which is arranged outside the container 17, only when necessary. As compared with a structure in which the connectors 39 are always connected to the pipes, pipes do not interference with operations such as the removal of the cover body 19 from the main body 18 or the attachment of the cover body 19 at the closing position.

The above embodiments may be modified in the following forms.

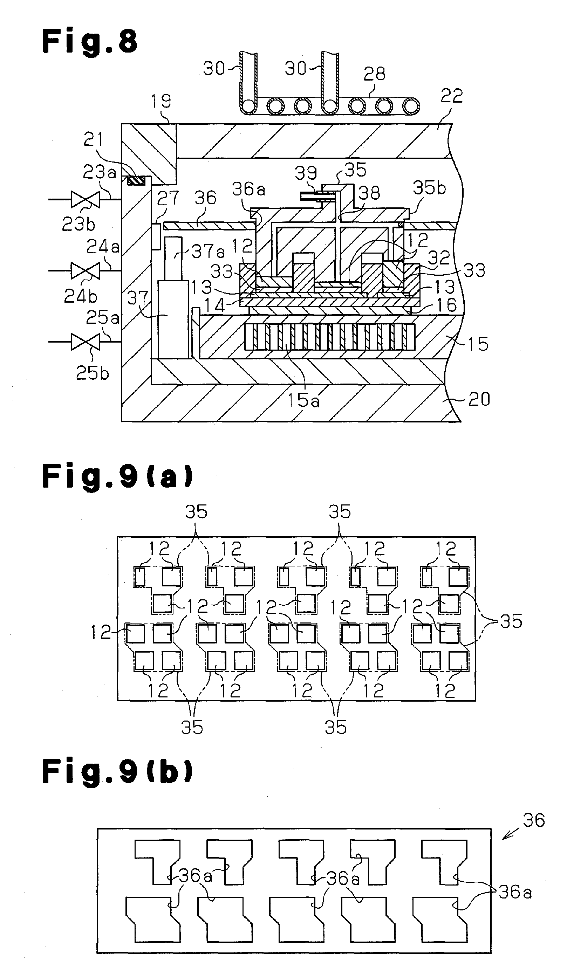

The layout, size, height, and the like of the semiconductor elements 12 are not limited in the manner described in the above embodiments. For example, referring to Fig. 8, a plurality of semiconductor elements 12 having different sizes and heights may be bonded to the ceramic substrate 14. Each weight 35 may be formed with dimensions enabling the weight 35 to extend over semiconductor elements (not shown) other than the three semiconductor elements. This would obtain the same advantages as the second embodiment.

The weights 35 do not all have to be of the same size and shape. For example, as shown in Fig. 9(a), the plurality of semiconductor elements 12 may be divided into a plurality of groups, each including a different number of semiconductor elements 12 (in the illustrated example, a group including three semiconductor elements 12 and a group including four semiconductor elements 12), and the weights 35 (shown by double-dashed lines) may be shaped in correspondence with the layout of the semiconductor elements 12 in each group. In this case, two types of holes 36a are formed in the weight holding jig 36 in correspondence with the shapes of the two types of weights 35, as shown in Fig. 9 (b) .

The weights 35 do not have to be spaced from the semiconductor elements 12 (electronic components) when the temperature of the solder is still high after the melted solder solidifies. The weights 35 may be spaced from the semiconductor elements 12 before the solder solidifies as long as the weights 35 are spaced from the semiconductor elements 12 after the melted solder wets the bonding portions of the metal circuits 13 and the bonding surfaces of the semiconductor elements 12 and spreads out therebetween. More specifically, the weights 35 may be spaced from the electronic components at any timing from when the melted solder wets the bonding portions and the bonding surfaces of the electronic components and spreads out therebetween to when the melted solder solidifies and the temperature of the solder is still high. The determination of whether the melted solder has wet the bonding portions of the metal circuits 13 and the bonding surfaces of the semiconductor elements 12 and spread out therebetween may be performed by, for example, optically or visually checking for the formation of a fillet around each semiconductor element 12.

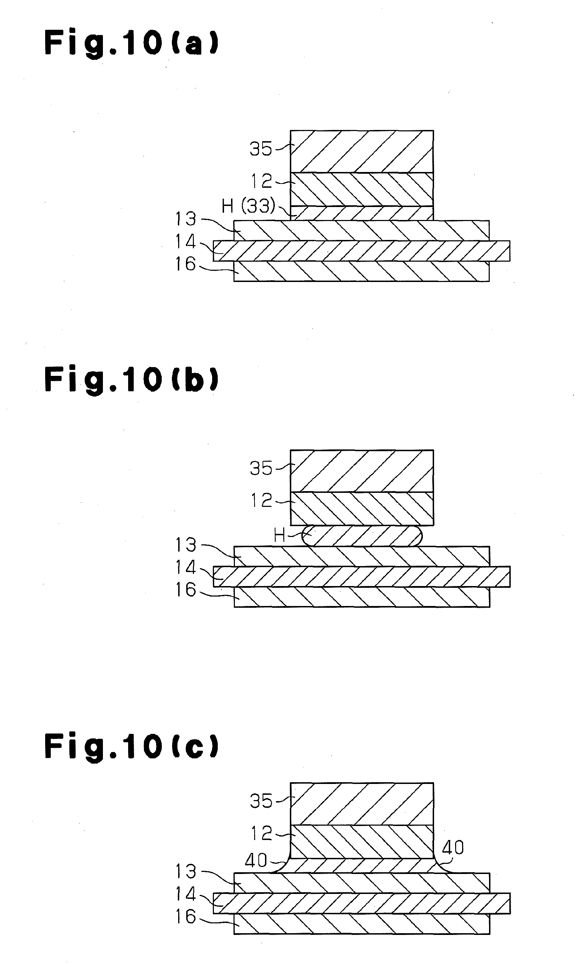

In detail, Fig. 10(a) shows a solder sheet 33, a semiconductor element 12 (electronic component), and a weight 35, which are arranged on a metal circuit 13. When the solder sheet 33 is heated and melted, in an initial melting state before the solder H becomes wet and spreads out, the melted solder H has an outwardly bulging curved peripheral surface as shown in Fig. 10(b). However, in a state in which the solder H wets the entire bonding surface of the semiconductor element 12 and spreads out therebetween, the solder H forms a fillet 40 as shown in Fig. 10(c).

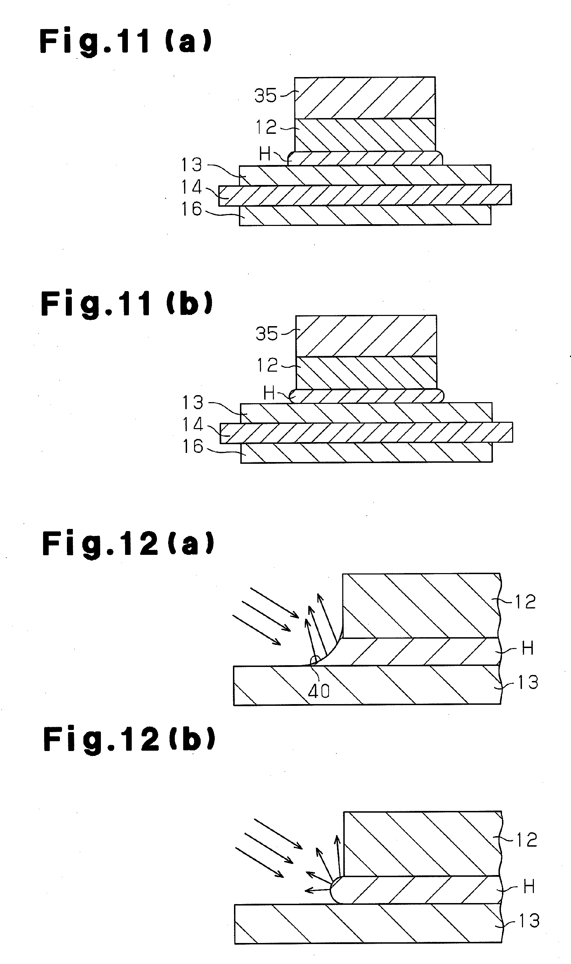

Fig. 11(a) shows a state in which a solder sheet 33 having a larger area than the bonding surface of a semiconductor element 12 is arranged between the semiconductor element 12 and a metal circuit 13. When the solder sheet 33 is heated and melted, the solder H spreads out over the entire bonding surface of the semiconductor element 12 as shown in Fig. 11(b) even in an initial melting stage. However, before the solder H becomes wet, the solder H has an outwardly bulging curved peripheral surface and does not have a filet. When the solder H becomes wet afterwards, the solder H forms a fillet 40 around the semiconductor element 12 as shown in Fig. 10(c). Depending on the pressing state of the weight 35, even when the solder sheet 33 has the same area as the bonding surface of the semiconductor element 12 as shown in Fig. 10(a), the solder H may spread out over the entire bonding surface of the semiconductor element 12 even in the initial melting stage of the solder H as shown in Fig. 11(b). However, as long as the solder H does not solidify, the peripheral surface of the surface is curved and bulges outward.

When the fillet 40 is formed on the solder H, the illumination of the peripheral portion of the semiconductor device 12 with light (as indicated by arrows) reflects the light in a certain direction as shown in Fig. 12(a). When the peripheral portion of the solder H forms a curved surface that bulges outward from the bonding surface of the semiconductor element 12, the illumination of the peripheral portion of the solder H diffuses light as shown in Fig. 12(b). Thus, the reflected light may be detected to determine whether or not the fillet 40 is formed.

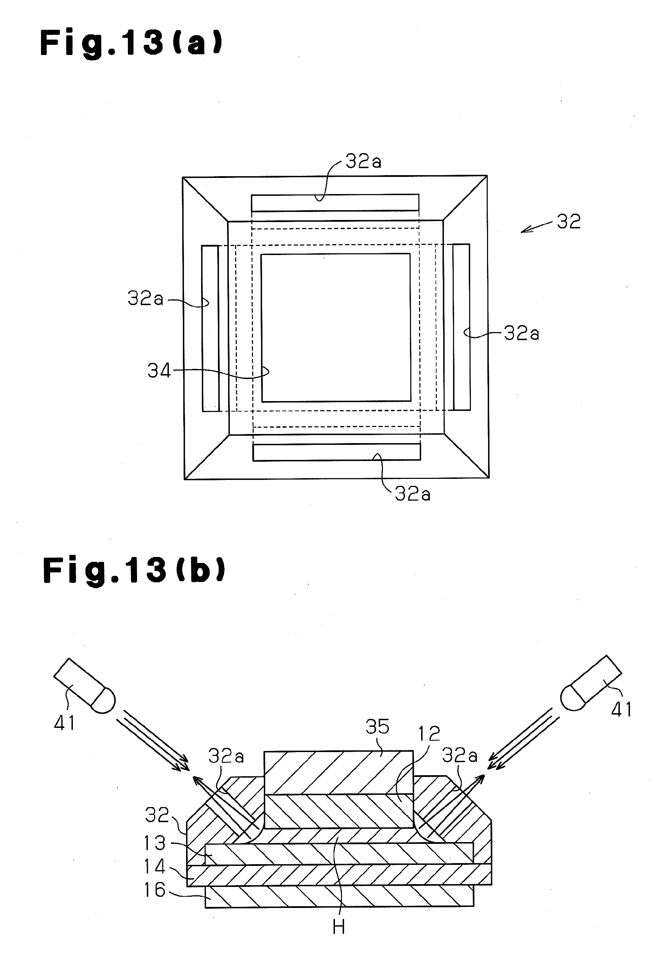

A method for optically determining whether or not the fillet 40 has been formed will now be described. As shown in Figs. 13(a) and 13(b), a jig 32 having elongated holes 32a is used to position the semiconductor element 12 and the weight 35 on the ceramic substrate 14. Light from an external source illuminates the periphery of the bonding surface of the semiconductor element 12 through the elongated holes 32a. When the solder H becomes wet, the solder H spreads out over the surface of the metal circuit 13 but the solder is being pulled by the bonding surface of the semiconductor element 12. Thus, the solder H does not spread so as to greatly extend out of the bonding surface. A satisfactory fillet 40 is formed so as to extend out from the periphery of the semiconductor element 12. Thus, the position of a satisfactory fillet 40 is the periphery of the semiconductor element 12. Accordingly, the positions of the elongated holes 32a and the angle between the direction of the light entering through the elongated holes 32a and the upper surface of the metal circuit 13 are set in a manner that light passing through the elongated holes 32a illuminates the periphery of the semiconductor element 12.

As shown in Fig. 13(b), light emitting and receiving devices 41 emit light toward the elongated holes 32a (as indicated by arrows) and receive light reflected from the periphery of the semiconductor element 12. The formation of a fillet 40 is determined based on the intensity of the light received by the light emitting and receiving devices 41. A reference value of the intensity of the reflection light for determining whether or not the fillet 40 is formed may be set, for example, based on intensities of light obtained in advance through experiments. The intensity of reflection light is obtained when emitting light in a state in which the fillet 40 has been formed, and the intensity of reflection light is obtained when emitting light in a state in which an outwardly bulging curved surface is formed. A light emitting unit and a light receiving unit that are independent from each other may be used in lieu of the light emitting and receiving device. The jig 32 does not have to have the elongated holes 32a and may have any hole through which light from the light emitting units can be emitted and through which reflection light can be received by the light receiving units.

In this manner, the weights 35 are spaced from the semiconductor elements 12 before the melted solder H solidifies, so that the melted solder H cools at a faster speed until it solidifies. As a result, the solder H has finer crystals. This improves the durability of the solder against heat fatigue during usage. As long as the melted solder H has wet the bonding portions and the bonding surfaces of the electronic components and spread out therebetween, even if the pressing force of the weights 35 is removed before the melted solder H solidifies, the surface tension of the solder H prevents the electronic components from being lifted, and the solder H remains spread out entirely wetting the bonding surfaces of the electronic components until it solidifies. If the soldering subject is cooled in a state in which the solder H is not wetting the bonding portion and the bonding surfaces even though the solder H is spread out entirely on the bonding surface of the semiconductor elements 12 as shown in the state of Fig. 11(b), the strength of the solder bonding portion would decrease in comparison with when the soldering subject is cooled in a state in which the solder H is wet. In this embodiment, however, the cooling of the soldering subject is started after checking the formation of the fillet 40. Thus, soldering obtains a high bonding strength. Further, the thickness of the solder H is prevented from being varied even when spacing the weights 35 from the semiconductor elements 12.

The formation of the fillet 40 does not necessarily have to be checked based on the intensity of reflection light of the light illuminating the periphery of the bonding surfaces of the semiconductor elements 12. For example, the formation of the fillet 40 may be checked from image information of the periphery of the bonding surfaces of the semiconductor elements 12.

The formation of the fillet 40 may be checked by visually observing the periphery of the bonding surfaces of the semiconductor elements 12 through the elongated holes 32a formed in the jig 32.

The stopping of the heating of the solder H and the spacing of the weights 35 from the semiconductor elements 12 do not have to be performed at the same time and may be performed after determining formation of the fillet 40. The weights 35 may be spaced before or after stopping the heating of the solder H. However, by spacing the weights 35 from the semiconductor elements 12 and stopping the heating of the solder H immediately after determining the formation of the fillet 40, the cooling speed at which the melted solder solidifies can be increased. This shortens the time required for the soldering operation.

When the soldering is performed in a reducing gas atmosphere while reducing gas is being supplied, the supply of the reducing gas is stopped immediately after the formation of the fillet 40 is determined. This reduces the used amount of reducing gas and lowers the soldering cost.

Instead of using the light emitting and receiving devices 41 or the like when checking for the formation of the fillet 40 as described above, it can be determined that the solder has become wet and spread out based on the time elapsed from a reference time point (for example, the time elapsed from when heating is started). In this case, the time normally required by the solder to become wet and spread out is obtained in advance through experiments. This simplifies the structure for determining whether the solder has become wet and spread out. The time required by the solder to become wet and spread out may be obtained through experiments conducted on the soldering subject with or without the jigs 32.

The drivers 37 do not have to be arranged below the weight holding jig 36 to support the weight holding jig 36 from below and move the weight holding jig 36 in the vertical direction. For example, the drivers 37 may be arranged above the weight holding jig 36 to support one of the upper, side, and lower surfaces of the weight holding jig 36 to move the weight holding jig 36 in the vertical direction. More specifically, linear actuators may be arranged so that their piston rods extend downward, with an electromagnet attached to the distal end of the piston rod of each driver, and an attraction unit, which is formed from a magnetic material, arranged on the weight holding jig 36 at a position corresponding to the electromagnet of each driver. The attraction units of the weight holding jig 36 attracted to the electromagnets to move the weight holding jig 36 together with the piston rods.

As one example of a structure in which the drivers 37 are arranged above the weight holding jig 36, linear actuators may be arranged such that their piston rods extend downward, and the distal ends of the piston rods are extendible through holes formed in the weight holding jig 36. An engagement member, which engages the lower surface of the weight holding jig 36, may be arranged on the distal end of the piston rod of each driver 37 to support the lower surface of the weight holding jig 36 and move the weight holding jig 36.

As one example of a structure in which the drivers 37 are arranged above the weight holding jig 36, the drivers 37 may be attached to the cover body 19.

The portions of the weights 35 that engage the weight holding jig 36 are not limited to the flanges 35b. For example, a plurality of projections that engage the weight holding jig 36 may be arranged on side surfaces of upper portions of the weights 35.

Each pressing surface 35a of the weight 35 does not have to be large enough to come in contact with the entire surface of the non-bonding surface of the corresponding semiconductor element 12. The pressing surface 35a of the weight 35 may be larger or smaller than the non-bonding surface of the corresponding semiconductor element 12. The jig 32 does not have to function to position the solder sheets 33, the semiconductor elements 12, and the weight 35. Alternatively, the jig 32 may function to position only the solder sheets 33 and the semiconductor elements 12.

In a structure in which the solder is melted with the heat generated by the weights 35 through induction heating, the weights 35 do not have to be formed from stainless steel. The weights 35 may be formed from any material suitable for induction heating. For example, the weights 35 may be formed from iron or graphite instead of stainless steel or may be formed from two conductive materials having different thermal conductivity coefficients.

The solder sheets 33 do not have to be arranged at positions corresponding to the bonding portions of the metal circuits 13. Alternatively, soldering paste may be applied at positions corresponding to the bonding portions of the metal circuits 13.

Methods other than induction heating may be performed to heat the solder to a temperature that is greater than or equal to the melting point. For example, the solder may be heated with an electric heater, which serves as a heating device, in the container 17.

The heat sink 15 of the circuit board 11, to which the ceramic substrates 14 are fixed, does not have to include the refrigerant passage 15a. Also, the circuit board 11 does not have to include the heat sink 15.

The cover body 19 may be fixed to the main body 18 and may be connected to the main body 18 so that the cover body 19 can open and close the main body 18.

It is preferable that at least the portion of the cover body 19 facing the high frequency heating coils 28 is formed from an electric insulating material. This portion does not have to be formed from glass and may be formed from, for example, ceramics or resin. Further, the cover body 19 may entirely be formed from the same electric insulating material.

When the strength of the cover body 19 has to be increased in accordance with the pressure difference between the inside and outside of the container 17, the cover body 19 may be formed from a composite of glass fibers and resin (glass fiber reinforced polymer (GFRP)). Alternatively, the cover body 19 may be formed from metal. It is preferable that the metal used as the material for the cover body 19 be a non-magnetic metal. When the cover body 19 is formed from a magnetic metal, it is preferable to use a magnetic metal with a higher electric resistance than the material for the weights 35. The cover body 19 may be formed from a composite of metal and insulating material. To effectively induce magnetic flux to the weights 35, it is preferable that ferromagnetic plates be arranged on upper distal ends of the weights 35.

Each high frequency heating coil 28 may be arranged to extend over a plurality of weights 35. This reduces the passages for supplying a high frequency current to the high frequency heating coils 28 and the passages for supplying coolant to the high frequency heating coils 28 and further simplifies the structure of the soldering apparatus HK.

The container 17 may be conveyed along a production line. The high frequency heating coils 28 may be arranged along a path on which the weights 35 are conveyed together with the container 17. In this case, each high frequency heating coil 28 may be shaped in accordance with the conveyance path. A plurality of high frequency heating coils 28 may be arranged along the conveyance path. This structure enables the container 17 to be heated while conveyed along the production line.

The high frequency heating coils 28 may be arranged to face the side surfaces of the weights 35.

The high frequency heating coils 28 may be arranged in the container 17 (sealed space S).

The electronic components may be electronic components other than the semiconductor elements 12. For example, the electronic components may be chip resistors or chip capacitors.

The soldering does not have to be performed in the container 17, which is sealable. For example, the soldering may be performed in a container with an inlet and an outlet. A circuit board 11 placed on a conveying device such as a belt conveyer is sent into the container through the inlet. The circuit board 11 is sent out of the container through the outlet. Alternatively, the soldering may be performed without the container, or more specifically, without any member surrounding the soldering subject.

## Claims

1. A method for soldering a bonding surface of an electronic component to a bonding portion defined on a circuit board, the method comprising:
placing the electronic component on the bonding portion of the circuit board with solder arranged between the electronic component and the bonding portion;
placing a weight on the electronic component;
heating and melting the solder while pressing the electronic component toward the circuit board with the weight; and
spacing the weight from the electronic component while the temperature of the solder is still high after the melted solder wets the bonding portion and the bonding surface of the electronic component and spreads out therebetween.

2. The soldering method according to claim 1, wherein the weight is spaced from the electronic component during a period from when the melted solder wets the bonding portion and the bonding surface of the electronic component and spreads out therebetween to when the temperature of the solder is still high after the melted solder solidifies.

3. The soldering method according to claim 1, wherein the weight is spaced from the electronic component during a period from when the melted solder wets the bonding portion and the bonding surface of the electronic component and spreads out therebetween to when the melted solder solidifies.

4. The soldering method according to claim 3, further comprising:
immediately stopping the heating of the solder and starting cooling of the solder when the melted solder wets the bonding portion and the bonding surface of the electronic component and spreads out therebetween.

5. The soldering method according to claim 3 or 4, wherein the weight is immediately spaced from the electronic component when the solder becomes wet and spreads out.

6. The soldering method according to any one of claims 1 to 5, further comprising:
illuminating a portion of the electronic component that is near the bonding surface with light;
determining whether a fillet is formed on the solder based on reflection light of the light; and
specifying the point of time when the fillet is formed as the point of time when the solder has become wet and spreads out.

7. The soldering method according to claim 1, further comprising:
stopping the heating of the solder after the solder melts, wherein the weight is spaced from the electronic component after the melted solder solidifies when the temperature of the solder is still high.

8. The soldering method according to any one of claims 1 to 7, further comprising:
moving the weight with a weight holding jig between a pressing position for pressing the electronic component and a spaced position spaced from the electronic component.

9. The soldering method according to claim 8, wherein the weight holding jig has the shape of a plate and includes a holding portion allowing insertion of the weight therethrough, the method further comprising:
moving the weight together with the weight holding jig in a state in which a projection arranged on the weight is engaged with an upper surface of the weight holding jig.

10. The soldering method according to claim 9, further comprising:
placing a plurality of electronic components respectively on a plurality of bonding portions defined on the circuit board with solder arranged between the electronic components and the bonding portions;
heating and melting the solder in a state in which weights are placed on corresponding ones of the plurality of electronic components; and
simultaneously moving the weights from the pressing position to the spaced position in a state in which the weights are held by corresponding ones of holding portions so that a positional relationship of the weights is maintained in a positional relationship for when the weights press the electronic components.

11. The soldering method according to claim 9 or 10, wherein the weight includes a passage, the passage opens in a pressing surface of the weight that is contactable with the electronic component, and a connector enabling connection of the passage to a negative pressure source is arranged on the weight at a portion other than the pressing surface, the method further comprising:
attracting the solder or the electronic component to the pressing surface of the weight by communicating negative pressure generated by the negative pressure source to the passage; and
moving the solder or the electronic component to the bonding portion in a state in which the solder or the electronic component is attracted to the pressing surface.

12. The soldering method according to any one of claims 8 to 11, wherein:
the soldering is performed in a container; and
the weight is moved together with the weight holding jig from the pressing position to the spaced position by a driver arranged in the container.

13. The soldering method according to any one of claims 1 to 12, further comprising:
generating heat with the weight through electromagnetic induction and transferring the heat of the weight to the solder via the electronic component.

14. The soldering method according to any one of claims 1 to 13, wherein:
the circuit board is formed by fixing a ceramic substrate, which includes a surface on which a metal circuit is arranged, to a metal heat sink, which includes a refrigerant passage.

15. The soldering method according to claim 14, further comprising:
using an aluminum or copper heat sink as the heat sink.

16. A method for manufacturing a semiconductor module formed by soldering a bonding surface of an electronic component to a bonding portion defined on a circuit board, the method comprising:
placing the electronic component on the bonding portion of the circuit board with solder arranged between the electronic component and the bonding portion;
placing a weight on the electronic component;
heating and melting the solder while pressing the electronic component toward the circuit board with the weight; and
spacing the weight from the electronic component while the temperature of the solder is still high after the melted solder wets the bonding portion and the bonding surface of the electronic component and spreads out therebetween.

17. The manufacturing method according to claim 16, wherein the weight is spaced from the electronic component during a period from when the melted solder wets the bonding portion and the bonding surface of the electronic component and spreads out therebetween to when the temperature of the solder is still high after the melted solder solidifies.

18. An apparatus for soldering electronic components respectively to a plurality of bonding portions defined on a circuit board, the apparatus comprising:
a container which accommodates the circuit board in a state in which the electronic components are respectively placed on the bonding portions with solder arranged between the electronic components and the bonding portions;
a plurality of weights which are respectively arrangeable on the electronic components for pressing the electronic components toward the circuit board;
a support arranged in the container to position and support the circuit board;
a weight holding jig arranged above the support and capable of holding the weights at positions respectively facing the bonding portions of the circuit board on the support;
a driver arranged in the container for driving the weight holding jig so that the weights held by the weight holding jig are movable between a pressing position for pressing the electronic components on the circuit board, which is positioned on the support, and a spaced position spaced from the electronic components; and
a heating device which heats and melts the solder.
